# EUROPÄISCHE PATENTANMELDUNG

(11) **EP 2 053 745 A1**
(43) Veröffentlichungstag der Anmeldung: **29.04.2009**
(21) Anmeldenummer: 08018023.5
(22) Anmeldetag: 15.10.2008
(51) Int. Cl.: H03K 17/96

(54) **Kapazitiver Berührungsschalter**

(30) Priorität: 24.10.2007 DE 102007050654
(71) Anmelder: Diehl AKO Stiftung & Co. KG, 88239 Wangen (DE)
(72) Erfinder: Heimann, Uwe, 88239 Wangen (DE)
(74) Vertreter: Diehl Patentabteilung

(57) **Zusammenfassung**

Ein kapazitiver Berührungsschalter für ein Bedienfeld eines elektrischen Haushaltsgeräts enthält eine Blende (10), eine in der Blende (10) angeordnete Sensorfläche (12), eine Leiterplatte (14), die in einem Abstand hinter der Blende (10) angeordnet ist, und ein kapazitives Sensorelement (16), das zwischen der Blende (10) und der Leiterplatte (14) angeordnet, mit der Leiterplatte (14) elektrisch leitend in Kontakt und der Sensorfläche (12) in der Blende (10) in einem Abstand zur Sensorfläche (12) zugeordnet ist. Außerdem ist die Sensorfläche (12) durch eine Platte (24) aus einem metallischen Material gebildet ist und zwischen der Platte (24) und dem kapazitiven Sensorelement (16) ist ein nichtleitender Isolierkörper (32) angeordnet.

## Beschreibung

Die vorliegende Erfindung betrifft einen kapazitiven Berührungsschalter nach dem Oberbegriff des Anspruchs 1.

In vielen elektrischen Geräten, insbesondere auch in Haushaltsgeräten wie Herden, Kochfeldern, Mikrowellenöfen, Spülmaschinen, Waschmaschinen und dergleichen, werden immer häufiger Berührungsschalter eingesetzt, die durch ein einfaches Berühren durch einen Benutzer einen bestimmten Schaltvorgang auslösen. Im Fall eines kapazitiven Berührungsschalters bildet ein kapazitives Sensorelement zusammen mit dem Finger eines Benutzers über ein als Dielektrikum wirkendes Berührungsfeld eine Kapazität, die entsprechend dem Betätigen des Berührungsschalters, d.h. dem Berühren oder Nicht-Berühren eines dem kapazitiven Sensorelement zugeordneten Berührungsfeldes variabel ist. Die Veränderung der Kapazität des kapazitiven Sensorelements durch eine Berührung durch den Benutzer wirkt sich entsprechend auf ein Ausgangssignal der Sensorschaltung aus, was von einer angeschlossenen Auswerteschaltung entsprechend als eine Betätigung des kapazitiven Berührungsschalters ausgewertet wird. Ein derartiger kapazitiver Berührungsschalter ist zum Beispiel aus der DE 32 45 803 A1 bekannt.

Ferner offenbart die DE 10 2005 053 792 A1 der Anmelderin einen solchen kapazitiven Berührungsschalter, bei dem das kapazitive Sensorelement eine Druckfeder aus einem elektrisch leitenden Material und ein Kontaktelement aus einem elektrisch leitenden Material, das auf der dem Berührungsfeld zugewandten Seite der Druckfeder angeordnet ist und mit der Druckfeder elektrisch leitend in Kontakt ist, aufweist. Die Druckfeder, die sich gegen die Leiterplatte und das Kontaktelement abstützt, gewährleistet einen zuverlässigen Kontakt zwischen dem Kontaktelement des Sensorelements und der Unterseite des Berührungsfeldes, wodurch die Funktionsfähigkeit des kapazitiven Berührungsschalters auch bei Temperaturänderungen, Alterungsprozessen der Bauelemente, Toleranzen und Positionsungenauigkeiten der Bauelemente und der dergleichen verbessert ist.

Es ist bei den herkömmlichen kapazitiven Berührungsschaltern üblich, für die Sensorfläche des Bedienfeldes, welche vom Benutzer zum Betätigen des kapazitiven Berührungsschalters berührt werden, eine metallisierte Kunststofffläche, eine Kunststofffläche mit einer Metallisierung auf der dem Sensorelement zugewandten Seite, eine Kunststofffläche mit einem Metallplättchen auf der dem Sensorelement zugewandten Seite oder dergleichen zu verwenden.

Es ist eine Aufgabe der vorliegenden Erfindung, einen kapazitiven Berührungsschalter zu schaffen, der eine benutzerfreundlichere Bedienung vorsieht.

Diese Aufgabe wird durch einen kapazitiven Berührungsschalter mit den Merkmalen des Anspruchs 1 gelöst. Vorteilhafte Ausgestaltungen und Weiterbildungen der Erfindung sind Gegenstand der abhängigen Ansprüche.

Der kapazitive Berührungsschalter weist eine Blende, eine in der Blende angeordnete Sensorfläche, eine Leiterplatte, die in einem Abstand hinter der Blende angeordnet ist, und ein kapazitives Sensorelement, das zwischen der Blende und der Leiterplatte angeordnet, mit der Leiterplatte elektrisch leitend in Kontakt und der Sensorfläche in der Blende in einem Abstand zur Sensorfläche zugeordnet ist, auf. Ferner ist die Sensorfläche durch eine Platte aus einem metallischen Material gebildet und zwischen der Platte und dem kapazitiven Sensorelement ist ein nichtleitender Isolierkörper angeordnet.

Da die Sensorfläche durch eine Platte aus einem metallischen Material gebildet ist, erfährt der Benutzer beim Berühren der Sensorfläche im Gegensatz zu den oben beschriebenen herkömmlichen Berührungsschaltern ein echtes Metallgefühl, das erfahrungsgemäß als angenehm empfunden wird und daher eine benutzerfreundliche Bedienung vorsieht. Um das für den kapazitiven Berührungsschalter erforderliche Dielektrikum zwischen dem Sensorelement und dem Finger des Benutzers zu schaffen, ist erfindungsgemäß zwischen der Platte und dem kapazitiven Sensorelement ein Isolierkörper angeordnet.

Wenn der so aufgebaute kapazitive Berührungsschalter in Verbindung mit einer Blende aus einem metallischen Material eingesetzt wird, so muss zusätzlich zwischen der Platte und der Blende ein elektrisch isolierendes Element angeordnet werden.

In diesem Fall kann das elektrisch isolierende Element zum Beispiel aus einem nichtleitenden Kunststoff gebildet sein, sich farblich von der Blende und/oder der Platte abheben und/oder gegenüber der Blende in Richtung zur Benutzerseite hin vorstehen.

In einer weiteren Ausgestaltung der Erfindung ist das elektrisch isolierende Element aus einem lichtdurchlässigen Material gebildet und auf der Platine ist wenigstens ein Leuchtmittel (zum Beispiel eine Leuchtdiode) vorgesehen, das dem elektrisch isolierenden Element zugeordnet. In diesem Fall ist zwischen dem elektrisch isolierenden Element und dem wenigstens einen Leuchtmittel vorzugsweise ein Lichtleitelement vorgesehen, wobei das Lichtleitelement und der Isolierkörper integral ausgebildet sein können. Bei dieser Konstruktion des Berührungsschalters kann das elektrisch isolierende Element beleuchtet werden, um dem Benutzer die Position der Sensorfläche zu verdeutlichen und/oder den aktuellen Schaltzustand des Berührungsschalters anzuzeigen.

Falls die Blende aus einem Kunststoff, d.h. einem elektrisch nicht leitenden Material gebildet ist, ist die Platte alternativ einfach in die Blende eingesetzt oder auf die Blende aufgesetzt.

In einer weiteren Ausgestaltung dieser Variante ist die Blende in der Nähe der Platte zumindest teilweise aus einem lichtdurchlässigen Material gebildet und auf der Platine ist wenigstens ein Leuchtmittel vorgesehen, wobei zwischen der Blende und dem wenigstens einen Leuchtmittel vorzugsweise ein Lichtleitelement vorgesehen ist. Bei dieser Konstruktion des Berührungsschalters kann die unmittelbare Blendenumgebung der Sensorfläche beleuchtet werden, um dem Benutzer die Position der Sensorfläche zu verdeutlichen und/oder den aktuellen Schaltzustand des Berührungsschalters anzuzeigen.

In einer weiteren Ausgestaltung der Erfindung kann bei dem kapazitiven Berührungsschalter einer der beiden obigen Varianten die Platte eine Durchbrechung aufweisen und auf der Platine ein Leuchtmittel vorgesehen sein, das der Durchbrechung zugeordnet ist, wobei zwischen der Durchbrechung und dem Leuchtmittel vorzugsweise ein Lichtleitelement vorgesehen ist, welches bevorzugt integral mit dem Isolierkörper ausgebildet ist. Bei dieser Konstruktion des Berührungsschalters kann die Sensorfläche selbst eine Lichtmarkierung haben, um dem Benutzer zum Beispiel die Position der Sensorfläche zu verdeutlichen und/oder den aktuellen Schaltzustand des Berührungsschalters anzuzeigen.

In einer noch weiteren Ausgestaltung der Erfindung kann das kapazitive Sensorelement des erfindungsgemäßen Berührungsschalters so konstruiert sein, wie dies zum Beispiel in der bereits eingangs genannten DE 10 2005 053 792 A1 der Anmelderin beschrieben ist.

Insbesondere kann das kapazitive Sensorelement eine Druckfeder aus einem elektrisch leitenden Material und ein Kontaktelement aus einem elektrisch leitenden Material, das auf der der Sensorfläche zugewandten Seite der Druckfeder angeordnet ist und mit der Druckfeder elektrisch leitend in Kontakt ist, aufweisen. Zusätzlich kann auf der Leiterplatte ein weiteres Kontaktelement zur elektrischen Kontaktierung mit der Druckfeder vorgesehen sein oder das kapazitive Sensorelement kann ferner auf seiner der Leiterplatte zugewandten Seite ein weiteres Kontaktelement zur elektrischen Kontaktierung mit der Leiterplatte aufweisen.

Obige sowie weitere Merkmale und Vorteile der Erfindung werden aus der nachfolgenden Beschreibung bevorzugter, nicht-einschränkender Ausführungsbeispiele unter Bezug auf die beiliegenden Zeichnungen besser verständlich. Darin zeigen:
- Fig. 1: eine schematische Perspektivansicht eines Bedienfeldes mit mehreren kapazitiven Berührungsschaltern gemäß der vorliegenden Erfindung;
- Fig. 2: eine schematische Seitenperspektivansicht d kapazitiven Berührungsschalter von Fig. 1, teilweise im Schnitt; und
- Fig. 3: eine schematische Explosionsdarstellung der kapazitiven Berührungsschalters von Fig. 1.

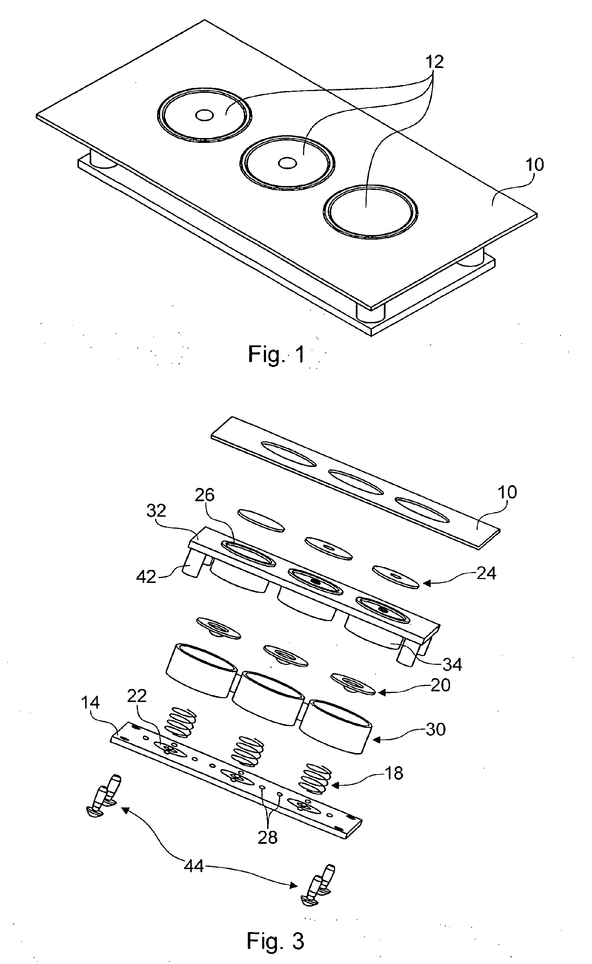

Fig. 1 zeigt einen Ausschnitt eines Bedienfeldes eines elektrischen Geräts, insbesondere eines elektrischen Haushaltsgeräts (Herd, Kochfeld, Mikrowellenofen, Spülmaschine, Waschmaschine und dergleichen) schematisch in Perspektivansicht.

Mit 10 ist eine dem Benutzer zugewandte Blende aus einem metallischen Material bezeichnet, in der mehrere (in diesem Ausführungsbeispiel drei) durch den Benutzer zu bedienende Sensorflächen 12 jeweils eines kapazitiven Berührungsschalters zum Einstellen, von Programmen, Funktionen, Parameter, usw. des jeweiligen Haushaltsgeräts angeordnet sind. Erfindungsgemäß sind diese Sensorflächen 12 jeweils durch eine Platte bzw. Scheibe aus einem metallischen Material (nachfolgend auch kurz mit Metallplatte bezeichnet) gebildet, wie nachfolgend näher erläutert.

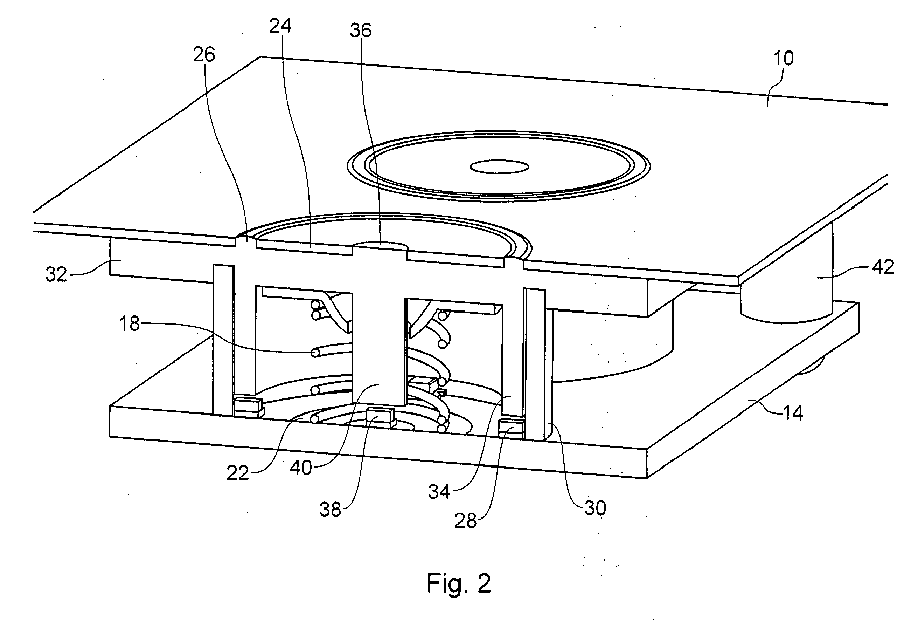

Bezug nehmend auf Fig. 2 und 3 wird nun der Aufbau der kapazitiven Berührungsschalter des Bedienfeldes von Fig. 1 in mehr. Einzelheiten erläutert.

In einem bestimmten Abstand hinter der Blende 10 ist eine Leiterplatte bzw. Platine 14 angeordnet, die mit diversen elektrischen Bauelementen (nicht dargestellt) bestückt ist und insbesondere eine Sensorschaltung und eine Auswerteschaltung für die kapazitiven Berührungsschalter enthält. Zwischen dieser Platine 14 und der Blende sind die kapazitiven Sensorelemente 16 der kapazitiven Berührungsschalter entsprechend den Sensorflächen 12 angeordnet.

Das kapazitive Sensorelement 16 dieser Berührungsschalter besteht im Wesentlichen aus einer Druckfeder 18 aus einem elektrisch leitenden Material, einem scheibenförmigen Kontaktelement 20 aus einem elektrisch leitenden Material, das auf der der Sensorfläche 12 zugewandten Seite der Druckfeder 18 (oben in Fig. 2) angeordnet ist, und einem weiteren Kontaktelement 22 aus einem elektrischen leitenden Material, das in Form einer Kontaktfläche auf der Leiterplatte 14 ausgebildet ist. Das Kontaktelement 20 und das weitere Kontaktelement 22 stehen jeweils mit der Druckfeder 18 elektrisch leitend in Kontakt, die sich gegen diese beiden Kontaktelemente 20, 22 abstützt. Auf diese Weise wird unabhängig von Temperaturschwankungen, Bauteiltoleranzen, Positionsungenauigkeiten und dergleichen immer ein ausreichend guter Kontakt des Sensorelements gewährleistet, wodurch die Funktionsfähigkeit des kapazitiven Berührungsschalters sichergestellt ist.

Anstelle der Kontaktfläche 22 auf der Platine 14 als weiteres Kontaktelement kann das weitere Kontaktelement auch analog dem Kontaktelement 20 als eine mit der Druckfeder 18 verbundene Scheibe aus einem elektrisch leitenden Material gebildet sein. Form und Größe der Kontaktelemente 20, 22 sind selbstverständlich nicht speziell eingeschränkt, sondern können an die Sensorfläche 12 und die Platine 14 jeweils optimal angepasst werden.

Da die Sensorfläche 12 des kapazitiven Berührungsschalters erfindungsgemäß durch eine Platte 24 aus einem metallischen Material (nachfolgend auch kurz als Metallplatte 24 bezeichnet) gebildet wird und die Blende 10 ebenfalls aus einem metallischen Material besteht, muss zwischen die Metallplatte 24 der Sensorfläche 12 und die Blende 10 ein elektrisch isolierendes Element 26 gesetzt sein. Im Fall einer scheibenförmigen Metallplatte 24 ist dieses elektrisch isolierende Element 26 als Isolierring geformt.

Das elektrisch isolierende Element 26 ist beispielsweise aus einem nichtleitenden Kunststoff gebildet, der sich zur besseren Kennzeichnung der Sensorfläche 12 innerhalb der Blende 10 farblich von der Blende 10 und/oder der Metallplatte 24 unterscheidet. Zusätzlich kann das elektrisch isolierende Element 26 gegenüber der Blende 10 in Richtung zur Benutzerseite hin vorstehen, d.h. erhaben ausgebildet sein, um den Isolierweg zu vergrößern. Insgesamt wird die Sensorfläche 12 in der Blende 10 durch das elektrisch isolierende Element 26 für den Benutzer deutlich markiert.

In einer speziellen Ausführungsform, wie sei in Fig. 2 und 3 veranschaulicht ist, kann das elektrisch isolierende Element 26 aus einem lichtdurchlässigen Material gebildet sein. Dann ist auf der Platine 14 wenigstens ein Leuchtmittel (zum Beispiel eine Leuchtdiode) 28 vorgesehen, das diesem elektrisch isolierenden Element 26 zugeordnet ist. Zusätzlich ist es von Vorteil, das kapazitive Sensorelement 16 und das wenigstens eine Leuchtmittel 28 auf der Platine 14 innerhalb eines lichtundurchlässigen Trennkörpers 30 anzuordnen, der beispielsweise ringförmig ausgebildet ist und einen Strahlengang für das von dem wenigstens einen Leuchtmittel 28 ausgesendete Licht zum elektrisch isolierenden Element 26 bildet. Bei dieser Konstruktion kann das elektrisch isolierende Element 26 mit Hilfe des Leuchtmittels 28 beleuchtet werden, um dem Benutzer die Position der Sensorfläche 12 zu verdeutlichen und ggf. je nach Farbe der Beleuchtung auch den Schaltzustand des kapazitiven Berührungsschalters anzuzeigen.

Da die Sensorfläche 12 des kapazitiven Berührungsschalters, wie oben erwähnt, durch die Metallplatte 24 gebildet wird, um dem Benutzer ein angenehmes Metallgefühl beim Berühren der Sensorfläche 12 zu vermitteln, müssen außerdem diese Metallplatte 24 und das Kontaktelement 20 des kapazitiven Sensorelements 16 voneinander über ein Dielektrikum getrennt sein, sodass diese beiden Elemente als die Elektroden eines Kondensators fungieren, dessen Kapazitätswert sich je nach Berühren oder Nichtberühren der Sensorfläche 12 durch einen Benutzer verändert.

Dieses isolierende Dielektrikum wird in dem Ausführungsbeispiel durch einen Isolierkörper 32 zum Beispiel aus einem nichtleitenden Kunststoff gebildet. Der Isolierkörper 32 ist zum Beispiel plattenförmig ausgebildet und unmittelbar an der Rückseite der Blende 10 angeordnet.

Falls das elektrisch isolierende Element 26 aus dem lichtdurchlässigen Material gebildet ist, ist es von Vorteil, zwischen diesem Element 26 und dem wenigstens einen zugeordneten Leuchtmittel 28 ein Lichtleitelement 34 vorzusehen. Dieses Lichtleitelement 34 ist vorzugsweise integral mit dem Isolierkörper 32 ausgebildet und erstreckt sich in einer Ringform innerhalb des lichtundurchlässigen Trennkörpers 30.

Wie insbesondere in Fig. 2 veranschaulicht, kann die Metallplatte 24 zusätzlich mit einer (im Allgemein zentralen) Durchbrechung36 versehen sein und auf der Platine 14 kann ein weiteres Leuchtmittel (zum Beispiel eine Leuchtdiode) 38 montiert sein, die der Durchbrechung 36 zugeordnet ist. Zwischen der Durchbrechung 36 und dem weiteren Leuchtmittel 38 erstreckt sich vorzugsweise ein weiteres Lichtleitelement 40, welches vorteilhafterweise integral mit dem Isolierkörper 32 ausgebildet ist. Auch auf diese Weise kann dem Benutzer die Position der Sensorfläche 12 innerhalb der Blende 10 verdeutlicht werden und ggf. je nach Farbe der Beleuchtung der Schaltzustand des Berührungsschalters angezeigt werden.

Die beleuchtete Durchbrechung 36 in der Metallplatte 24 kann entweder alternativ oder zusätzlich zu dem beleuchteten Isolierring 26 vorgesehen sein. Sind beide Arten von Beleuchtung vorhanden, so kann zum Beispiel der beleuchtete Isolierring 26 die Sensorfläche 12 markieren und die beleuchtete Durchbrechung 36 in der Metallplatte 24 kann dem Benutzer den Schaltzustand des kapazitiven Berührungsschalters anzeigen.

Wie in Fig. 2 und 3 angedeutet, sind an dem Isolierkörper 32 auf seiner der Platine 14 zugewandten Seite mehrere Abstandshülsen 42 vorgesehen, die vorzugsweise einstückig mit dem Isolierkörper 32 ausgebildet sind. Diese Abstandshülsen 42 dienen der Einhaltung eines konstanten Abstandes zwischen der Platine 14 und dem Isolierkörper 32 bzw. der Blende 10 und außerdem der Befestigung der gesamten Anordnung mittels Befestigungsschrauben 44, die durch entsprechende Löcher in der Platine 14 in die Abstandshülsen 42 eingeschraubt werden.

Während die vorliegende Erfindung oben unter Bezugnahme auf ein bevorzugtes Ausführungsbeispiel anhand der Figuren vollständig beschrieben worden ist, ist es für den Fachmann selbstverständlich, dass verschiedene Modifikationen und Varianten vorgenommen werden können, ohne den durch die Ansprüche definierten Schutzumfang zu verlassen.

Beispielsweise ist das kapazitive Sensorelement 16 nicht auf das in Fig. 2 veranschaulichte Sensorelement beschränkt. Das kapazitive Sensorelement 16 ist vorzugsweise wie das in der DE 10 2005 053 792 A1 offenbarte Sensorelement aufgebaut, auf deren Inhalt hiermit diesbezüglich Bezug genommen werden, kann aber auch andere Bauformen annehmen.

Des Weiteren wurde die vorliegende Erfindung oben anhand eines Ausführungsbeispiels beschrieben, bei dem die Blende 10 aus einem metallischen Material gebildet ist. Alternativ ist die vorliegende Erfindung auch auf kapazitive Berührungsschalter mit einer Blende aus einem nichtleitenden Material wie beispielsweise Kunststoff anwendbar. In diesem Fall kann auf das elektrisch isolierende Element 26 natürlich verzichtet werden, da seine Funktion bereits in der Blende 10 integriert ist. Die Metallplatte 24 ist in diesem Fall entweder auf die Blende 10 aufgesetzt oder in diese integriert. Alle weiteren oben beschriebenen Merkmale können analog auch auf einen solchen Berührungsschalter übertragen werden.

### BEZUGSZIFFERNLISTE

- 10: Blende
- 12: Sensorfläche
- 14: Leiterplatte
- 16: kapazitives Sensorelement
- 18: Druckfeder
- 20: Kontaktelement
- 22: Kontaktfläche
- 24: Metallplatte
- 26: elektrisch isolierendes Element
- 28: Leuchtmittel
- 30: Trennkörper
- 32: Isolierkörper
- 34: Lichtleitelement
- 36: Durchbrechung
- 38: Leuchtmittel
- 40: Lichtleitelement
- 42: Hülsen
- 44: Befestigungsschrauben

## Patentansprüche

**1.** Kapazitiver Berührungsschalter, mit einer Blende (10); einer in der Blende (10) angeordneten Sensorfläche (12); einer Leiterplatte (14), die in einem Abstand hinter der Blende (10) angeordnet ist; und einem kapazitiven Sensorelement (16), das zwischen der Blende (10) und der Leiterplatte (14) angeordnet, mit der Leiterplatte (14) elektrisch leitend in Kontakt und der Sensorfläche (12) in der Blende (10) in einem Abstand zur Sensorfläche (12) zugeordnet ist,
**dadurch gekennzeichnet,**
**dass** die Sensorfläche (12) durch eine Platte (24) aus einem metallischen Material gebildet ist; und
**dass** zwischen der Platte (24) und dem kapazitiven Sensorelement (16) ein nichtleitender Isolierkörper (32) angeordnet ist.

**2.** Kapazitiver Berührungsschalter nach Anspruch 1,
**dadurch gekennzeichnet,**
**dass** die Blende (10) aus einem metallischen Material gebildet ist und zwischen der Platte (24) und der Blende (10) ein elektrisch isolierendes Element (26) angeordnet ist.

**3.** Kapazitiver Berührungsschalter nach Anspruch 2,
**dadurch gekennzeichnet,**
**dass** das elektrisch isolierende Element (26) aus einem nichtleitenden Kunststoff gebildet ist.

**4.** Kapazitiver Berührungsschalter nach Anspruch 2 oder 3,
**dadurch gekennzeichnet,**
**dass** sich das elektrisch isolierende Element (26) farblich von der Blende (10) und/oder der Platte (24) unterscheidet.

**5.** Kapazitiver Berührungsschalter nach einem der Ansprüche 2 bis 4,
**dadurch gekennzeichnet,**
**dass** das elektrisch isolierende Element (26) gegenüber der Blende (10) in Richtung zur Benutzerseite hin vorsteht.

**6.** Kapazitiver Berührungsschalter nach einem der Ansprüche 2 bis 5,
**dadurch gekennzeichnet,**
**dass** das elektrisch isolierende Element (26) aus einem lichtdurchlässigen Material gebildet ist; und
**dass** auf der Platine (14) wenigstens ein Leuchtmittel (28) vorgesehen ist, das dem elektrisch isolierenden Element (26) zugeordnet ist.

**7.** Kapazitiver Berührungsschalter nach Anspruch 6,
**dadurch gekennzeichnet,**
**dass** zwischen dem elektrisch isolierenden Element (26) und dem wenigstens einen Leuchtmittel (28) ein Lichtleitelement (34) vorgesehen ist.

**8.** Kapazitiver Berührungsschalter nach Anspruch 7,
**dadurch gekennzeichnet,**
**dass** das Lichtleitelement (34) und der Isolierkörper (26) integral ausgebildet sind.

**9.** Kapazitiver Berührungsschalter nach Anspruch 1,
**dadurch gekennzeichnet,**
**dass** die Blende (10) aus einem Kunststoff gebildet ist und die Platte (24) in die Blende (10) eingesetzt oder auf die Blende (10) aufgesetzt ist.

**10.** Kapazitiver Berührungsschalter nach Anspruch 9,
**dadurch gekennzeichnet,**
**dass** die Blende (10) in der Nähe der Platte (24) zumindest teilweise aus einem lichtdurchlässigen Material gebildet ist; und
**dass** auf der Platine (14) wenigstens ein Leuchtmittel (28) vorgesehen ist.

**11.** Kapazitiver Berührungsschalter nach Anspruch 10,
**dadurch gekennzeichnet,**
**dass** zwischen der Blende (10) und dem wenigstens einen Leuchtmittel (28) ein Lichtleitelement (34) vorgesehen ist.

**12.** Kapazitiver Berührungsschalter nach einem der Ansprüche 1 bis 11,
**dadurch gekennzeichnet,**
**dass** die Platte (24) eine Durchbrechung (36) aufweist; und
**dass** auf der Platine (14) ein weiteres Leuchtmittel (38) vorgesehen ist, das der Durchbrechung (36) zugeordnet ist.

**12.** Kapazitiver Berührungsschalter nach Anspruch 11,
**dadurch gekennzeichnet,**
**dass** zwischen der Durchbrechung (36) und dem weiteren Leuchtmittel (38) ein weiteres Lichtleitelement (40) vorgesehen ist.

**13.** Kapazitiver Berührungsschalter nach Anspruch 12,
**dadurch gekennzeichnet,**
**dass** das weitere Lichtleitelement (40) und der Isolierkörper (32) integral ausgebildet sind.

**14.** Kapazitiver Berührungsschalter nach einem der Ansprüche 1 bis 13,
**dadurch gekennzeichnet,**
**dass** das kapazitive Sensorelement (16) eine Druckfeder (18) aus einem elektrisch leitenden Material und ein Kontaktelement (20) aus einem elektrisch leitenden Material, das auf der der Sensorfläche (12) zugewandten Seite der Druckfeder (18) angeordnet ist und mit der Druckfeder elektrisch leitend in Kontakt ist, aufweist.

**15.** Kapazitiver Berührungsschalter nach Anspruch 14,
**dadurch gekennzeichnet,**
**dass** auf der Leiterplatte (14) eine Kontaktfläche (22) zur elektrischen Kontaktierung mit der Druckfeder (18) vorgesehen ist.

**16.** Kapazitiver Berührungsschalter nach Anspruch 14,
**dadurch gekennzeichnet,**
**dass** das kapazitive Sensorelement (16) ferner auf seiner der Leiterplatte (14) zugewandten Seite ein weiteres Kontaktelement zur elektrischen Kontaktierung mit der Leiterplatte (14) aufweist.
